(19) Europäisches Patentamt
European Patent Office
Office européen des brevets

(11) **EP 2 627 467 B1**

(12) **FASCICULE DE BREVET EUROPEEN**

(45) Date de publication et mention
de la délivrance du brevet:
**13.06.2018 Bulletin 2018/24**

(21) Numéro de dépôt: **11769891.0**

(22) Date de dépôt: **14.10.2011**

(51) Int Cl.:
**C01B 33/037** (2006.01)   **H01L 31/0368** (2006.01)
**H01L 31/18** (2006.01)

(86) Numéro de dépôt international:
**PCT/EP2011/068007**

(87) Numéro de publication internationale:
**WO 2012/049300 (19.04.2012 Gazette 2012/16)**

(54) **ELABORATION DE SILICIUM POLYCRISTALLIN PAR FRITTAGE NATUREL POUR APPLICATIONS PHOTOVOLTAÏQUES**

HERSTELLUNG VON POLYKRISTALLINEM SILIZIUM ANHAND VON NATÜRLICHER SINTERUNG FÜR FOTOVOLTAIKANWENDUNGEN

PRODUCTION OF POLYCRYSTALLINE SILICON BY NATURAL SINTERING FOR PHOTOVOLTAIC APPLICATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.10.2010 FR 1058441**

(43) Date de publication de la demande:
**21.08.2013 Bulletin 2013/34**

(73) Titulaire: **Commissariat à l'Energie Atomique et aux Energies Alternatives**
**75015 Paris (FR)**

(72) Inventeurs:
• **LEBRUN, Jean-Marie**
**35750 IFFENDIC (FR)**
• **MISSIEN, Jean-Michel**
**F-38400 Saint Martin D'Heres (FR)**
• **PASCAL, Céline**
**F-38410 Saint Martin D'Uriage (FR)**
• **GARANDET, Jean-Paul**
**F-73370 Le Bourget du Lac (FR)**
• **SERVANT, Florence**
**F-38410 Vaulvaneys Le Haut (FR)**

(74) Mandataire: **Ilgart, Jean-Christophe**
**BREVALEX**
**95, rue d'Amsterdam**
**75378 Paris Cedex 8 (FR)**

(56) Documents cités:
WO-A1-2004/055909    FR-A1- 2 934 186
JP-A- 7 017 704    JP-A- 2002 009 320
US-A1- 2009 233 426

• **COBLENZ W S: "The physics and chemistry of the sintering of silicon", JOURNAL OF MATERIALS SCIENCE UK, vol. 25, no. 6, juin 1990 (1990-06), pages 2754-2764, XP002629952, ISSN: 0022-2461 cité dans la demande**
• **GRESKOVICH C ET AL: "SINTERING OF COVALENT SOLIDS", JOURNAL OF THE AMERICAN CERAMIC SOCIETY, BLACKWELL PUBLISHING, MALDEN, MA, US, vol. 59, no. 7/08, 1 juillet 1976 (1976-07-01), pages 336-343, XP002055328, ISSN: 0002-7820 cité dans la demande**
• **WU C-Y ET AL: "TRANSPORT PROPERTIES OF THERMAL OXIDE FILMS GROWN ON POLYCRYSTALLINE SILICON-MODELING AND EXPERIMENTS", IEEE TRANSACTIONS ON ELECTRON DEVICES, IEEE SERVICE CENTER, PISACATAWAY, NJ, US, vol. 34, no. 7, 1 July 1987 (1987-07-01), pages 1590-1602, XP000836681, ISSN: 0018-9383**

**Description**

**DOMAINE TECHNIQUE ET ART ANTERIEUR**

La présente invention concerne la fabrication par la technique du frittage naturel de matériaux de type semi-conducteur. Le procédé employé permet de contrôler la densité et la porosité du matériau traité en fonction de l'épaisseur de la couche d'oxyde présente à sa surface.

Un procédé selon l'invention offre la possibilité d'utiliser la technique du frittage naturel pour réaliser des plaquettes de dimensions et de propriétés adaptées à des applications dans les domaines de l'électronique et du photovoltaïque, entre autres.

Le silicium est le principal élément utilisé pour la fabrication de composants électroniques et photovoltaïques. Pour atteindre les propriétés recherchées dans ces domaines, on utilise du silicium d'une grande pureté (>99,999 %). Le silicium purifié est généralement conditionné sous forme de lingots. Or, dans les domaines cités précédemment, le silicium est utilisé sous forme de plaquette dont l'épaisseur est de l'ordre de quelques dizaines à quelques centaines de $\mu$m, ces dimensions sont très inférieures à sa largeur et sa longueur (voir document FR 2 940 520). On procède alors à une mise en forme du matériau par des découpes successives. Ces étapes sont coûteuses en temps, en moyens et en matière. En effet, la quantité de matière perdue peut atteindre 50 %. Cela représente un surcoût d'environ 10 % à 25 % sur le procédé global de fabrication d'un module photovoltaïque. La mise au point d'un procédé d'élaboration de plaquettes de silicium polycristallin, sans étape de découpe, est donc un enjeu capital.

La métallurgie des poudres offre une solution attrayante. Elle permet la mise en forme du matériau avant sa densification, qui est réalisée par traitement thermique. Ainsi, les étapes de découpe sont supprimées. Ce procédé de fabrication est donc souple, rapide et économique.

Il existe deux techniques de frittage : sous ou sans charge. La charge consiste à appliquer une force extérieure sur un échantillon, lors du traitement thermique, afin d'en favoriser la densification. L'utilisation d'un matériau en contact avec l'échantillon est un facteur de risques de contamination et d'adhésion avec le fritté. De plus, il est délicat d'exercer une force de manière homogène sur un échantillon et donc d'avoir un échantillon de densité homogène. Le frittage sous ou avec charge ne permet pas non plus d'obtenir des plaquettes de pureté suffisante pour des applications dans les domaines de l'électronique et du photovoltaïque.

La seconde technique de frittage, dite technique de frittage naturel, sans charge ou sans application d'une force extérieure, ne permet pas d'atteindre des taux de densité importants pour des matériaux covalents. Il est donc difficile, par frittage naturel, d'obtenir des plaquettes de hautes densités. Cette difficulté à densifier a été confirmée expérimentalement par plusieurs études, notamment par C. GRESKOVICH et al. (Sintering of Covalent Solids, Journal of the American Ceramic Society, 59(7-8) :336-343, 1976).

Pour le silicium, diverses hypothèses sont avancées pour expliquer cette difficulté:

- une énergie de joint de grain qui serait anormalement élevée, associée à un coefficient de diffusion au joint de grain qui serait anormalement faible ;

- la présence à la surface des particules d'une couche d'oxyde de silicium « natif », $SiO_2$, très stable, d'une épaisseur de l'ordre du nanomètre (Carl Wagner, Journal of Applied Physics, volume 29, number 9, september 1958).

A ce jour, aucune de ces hypothèses ne fait l'unanimité.

Il n'a donc pas été possible jusqu'à présent, d'obtenir par la technique du frittage naturel, des plaquettes de densité supérieures à 85% respectant les critères de pureté requis pour des applications dans le domaine du photovoltaïque (WO 2004/093202 A1).

Il se pose donc le problème de trouver un nouveau procédé de frittage naturel permettant d'obtenir des densités contrôlées.

Par ailleurs en vue de certaines applications (batteries notamment), on cherche à disposer de silicium à porosité contrôlée.

**EXPOSE DE L'INVENTION**

La présente invention selon les revendications en annexe porte sur un procédé de frittage naturel, ou sans charge, permettant l'élaboration d'une ou plusieurs plaquettes de matériaux covalents comme par exemple les matériaux semi-conducteurs, notamment le silicium ou le germanium. La présentation de l'invention faite ci-dessous peut être généralisée à ces divers matériaux.

L'invention concerne d'abord un procédé de frittage de silicium, sans charge, comportant :

- un positionnement d'un échantillon de silicium dans un four,
- un traitement thermique de cet échantillon, initialement sous forme granulaire ou sous forme de poudre, à au moins une température et au moins une pression partielle d'une ou plusieurs espèces oxydantes pour contrôler l'épaisseur d'au moins une couche d'oxyde de silicium à la surface de cet échantillon ou à la surface des grains,
- éventuellement, une mesure de variation de la masse de l'échantillon pendant le procédé de frittage.

Par un tel procédé, la densité et/ou la porosité et/ou la proportion d'oxyde de silicium sont contrôlées.

Au regard des travaux déjà réalisés, la densification par frittage naturel du silicium est a priori défavorable. Cette étape de frittage est couramment réalisée sous une atmosphère neutre ou réductrice. En effet, le frittage de poudre métallique sous ce type d'atmosphère permet de faciliter l'élimination des oxydes superficiels qui sont une « barrière » au frittage selon M. Munir (Z. A. MUNIR. Analytical treatment of the rôle of surface oxide layers in the sintering of metals. Journal of Materials Science, 14(11):2733-2740, 1979). Or, l'inventeur a constaté, de façon surprenante, un lien entre l'épaisseur de la couche d'oxyde présente pendant le procédé de frittage sans charge et le taux de densification et de porosité des matériaux obtenus.

L'invention permet le contrôle de la formation et/ou de l'élimination partielle ou totale, de la couche d'oxyde à la surface de l'échantillon lors du procédé de frittage afin d'obtenir un matériau de densité et de porosité contrôlées.

L'épaisseur de la couche d'oxyde peut en outre être calculée en fonction des mesures de variation de masse du matériau et/ou calculée à partir d'un modèle cinétique simple.

Un procédé selon l'invention peut être précédé d'une étape de mise en forme, par exemple par compression de l'échantillon ou du matériau. La pièce à cru (ou pièce préformée) peut notamment résulter d'une mise en forme par des procédés très variés tels que la compression uniaxiale ou isostatique, à froid ou à chaud. Un des modes de mise en forme selon la technique du Métal Injection Molding (voir FR 2 931 297) peut également convenir. Par exemple, une pression importante est appliquée pour favoriser l'obtention d'une densité élevée, une pression faible pour favoriser la porosité de l'échantillon ou du comprimé.

L'épaisseur de l'échantillon, avant le procédé de frittage et selon au moins une direction, peut être inférieure à quelques millimètres, de préférence inférieure à 1 millimètre. L'échantillon selon au moins une dimension, est le plus fin possible afin de limiter les éventuels phénomènes de gradient, lors de la diffusion de gaz à l'extérieur et/ou à l'intérieur du comprimé.

Les poudres peuvent être de faible diamètre équivalent, par exemple inférieure à 500 nm, par exemple entre 300 nm et 100 nm. Les poudres sont alors obtenues, par exemple, par décomposition de gaz précurseurs comme le silane. Des grains de poudre de faible diamètre pourront avantageusement être mis en forme préalablement avec au moins une pression faible, typiquement inférieure à 600 MPa afin d'éviter tout blocage du système de réalisation de la préforme.

Ces poudres de faible diamètre possèdent une surface spécifique élevée (> 5 $m^2/g$), éventuellement une quantité d'oxyde à leur surface. Pour une épaisseur d'oxyde donnée, une poudre ayant une valeur de surface spécifique élevée comporte une quantité de silice plus importante, comparée à une poudre ayant une surface spécifique de plus faible valeur. A quantité égale de silicium traité, l'oxyde est ainsi conservé à plus haute température durant le procédé de frittage ce qui favorise la densification.

Les poudres de diamètre supérieur à 500 nm peuvent être obtenues par des techniques classiques de broyage. Pour ces grains de plus gros diamètre, par exemple entre 500 $\mu$m et 5 $\mu$m, une mise en forme préalable sera avantageusement réalisée avec au moins une pression forte, typiquement supérieure ou égale à 900 MPa. Cette ou ces pressions fortes permettent d'obtenir un échantillon avec une tenue mécanique suffisante pour garder sa forme. Les grains de poudre de plus gros diamètre peuvent être préférés pour l'obtention d'un matériau possédant de gros grains et donc de moindre défectivité afin que la durée de vie des porteurs de charge soit supérieure au temps nécessaire à leur collecte. On peut avoir des grains de taille intermédiaire, par exemple entre 5 $\mu$m et 500 nm, dont la mise en forme est réalisée préalablement avec les mêmes pressions fortes. Les poudres peuvent comporter une épaisseur d'oxyde natif comprise entre 50 nm et zéro, de préférence entre 3 nm et 0.

L'échantillon peut être constitué d'un mélange de poudre comportant des grains de dimensions différentes afin de favoriser la croissance des grains et la densification du mélange. En effet, les poudres fines, qui ont une surface spécifique plus élevée, favorisent le phénomène de densification lors du procédé de frittage. Le phénomène de croissance des grains est quant à lui favorisé par la présence de grains très dispersés en taille. La présence de gros grains est une caractéristique recherchée pour des applications en photovoltaïque. Un procédé selon l'invention permet le contrôle de la densification de l'échantillon et/ou de la taille des grains de l'échantillon quel que soit la granulométrie de la poudre utilisée.

Selon l'invention, l'atmosphère qui entoure l'échantillon comporte une ou plusieurs espèces oxydantes, c'est-à-dire, une espèce de composition $RO_n$ où n est un nombre positif et R un élément chimique. L'atmosphère peut être composée d'un gaz vecteur neutre et d'une ou de plusieurs espèces oxydantes vis-à-vis du matériau, par exemple de type $O_2$ et/ou $H_2O$, et/ou CO, et/ou de préférence SiO.

La pression (ou pression partielle oxydante) et/ou le débit en espèce oxydante et/ou la température peuvent varier ou rester constants lors du procédé de frittage pour contrôler l'épaisseur de la couche d'oxyde sur l'échantillon ou du matériau.

L'épaisseur de la couche d'oxyde peut être contrôlée de façon à obtenir une densité et/ou une teneur en oxygène et/ou en silice dans le matériau souhaité. Cette épaisseur peut être homogène ou non homogène à l'échelle de l'échantillon ou du comprimé traité, et/ou à l'échelle de la poudre le composant avant frittage.

On peut également contrôler la taille des pores de l'échantillon, après élimination de la couche d'oxyde, en fonction du traitement thermique.

Un mode de réalisation de l'invention comporte un ou plusieurs paliers lors du traitement thermique afin de maitriser le grossissement de la taille des grains et des pores de l'échantillon.

En outre, le retrait de l'échantillon peut être mesuré et éventuellement la variation de volume calculée, à partir de cette mesure, pendant le procédé de frittage selon l'invention.

On peut aussi réaliser un calcul de densité du matériau à partir des mesures et/ou des calculs de masse et du retrait du matériau.

La vitesse de montée en température et/ou le débit de l'espèce oxydante peuvent être choisis de façon à contrôler la vitesse d'attaque de la couche d'oxyde. On peut ainsi limiter ou favoriser l'oxydation du silicium lors du procédé de frittage selon l'invention.

L'épaisseur de l'échantillon, après traitement selon l'un des procédés de frittage précédents, et selon au moins une direction, est suffisante pour permettre sa manipulation. Au moins une épaisseur du comprimé peut être supérieure à 10 ou 50 $\mu$m, ou comprise entre 100 et 500 $\mu$m, de préférence égale à environ 300 $\mu$m.

L'invention concerne également un dispositif de frittage sans charge, selon les revendications en annexe, de frittage de silicium de préférence, qui comporte :

- un four,
- des moyens de contrôle de la température de l'enceinte du four,
- des moyens de contrôle de la pression partielle oxydante dans l'enceinte du four,
- des moyens commandant les moyens de contrôle de la température et de la pression partielle oxydante dans le four de sorte à contrôler l'épaisseur de la couche d'oxyde sur le silicium.

Le dispositif peut également comporter des moyens de mesure de variation de la masse de l'échantillon pendant le traitement thermique.

Le dispositif peut aussi comporter des moyens de mesure de retrait d'un échantillon de silicium, par contact (par exemple à l'aide d'un palpeur) ou à distance (par exemple à l'aide de moyens optiques).

Selon un mode de réalisation du dispositif, un système de vannes reliées à un gaz vecteur neutre (par exemple de l'hélium ou de l'argon) et un gaz oxydant (par exemple de l'eau) permet de contrôler la proportion, le débit et la pression du mélange de ces gaz dans l'enceinte du four.

Une variante du dispositif selon l'invention peut comporter des moyens de calcul de l'épaisseur d'une couche d'oxyde en fonction des mesures de variation de masse du matériau et/ou d'un modèle cinétique simple de calcul de la masse de l'échantillon.

Un tel dispositif peut comporter en outre des moyens de calcul de densité du matériau à partir des mesures de variations de masse et/ou d'un modèle cinétique simple de calcul de la masse de l'échantillon et des mesures de retrait du matériau.

Un dispositif selon l'invention peut comporter des moyens électroniques reliés à un ou plusieurs des éléments précédents de manière à pouvoir contrôler un ou plusieurs paramètres du dispositif. Selon une alternative, les moyens électroniques peuvent réaliser un ou plusieurs calculs comme par exemple le calcul d'épaisseur de la couche d'oxyde sur le matériau et/ou du volume de l'échantillon et/ou de la densité et/ou de la porosité et/ou de la proportion du matériau et de son oxyde.

Un tel dispositif peut permettre à un opérateur de contrôler l'ensemble du dispositif par l'intermédiaire d'un moyen d'affichage des données et d'une interface de commande (par exemple un clavier) reliés aux moyens électroniques.

Un produit selon l'invention comporte ou est constitué de silicium et de silice rémanente en proportion et densité contrôlées afin de créer des zones ponctuelles permettant le piégeage d'impuretés dans le matériau, telles que l'oxygène et/ou le carbone et/ou des impuretés métalliques (effet « getter »).

Le produit est obtenu de préférence sous forme de plaquette dont l'épaisseur est supérieure à 50 $\mu$m afin de pouvoir le manipuler.

## BREVE DESCRIPTION DES DESSINS

Les figures 1A et 1B sont des schémas d'un exemple de réalisation d'un dispositif selon l'invention composé d'un four, de moyens de support d'échantillons, de moyens de mesure de retrait de l'échantillon, de moyens de contrôle de la température et de l'atmosphère dans l'enceinte du four (figure 1B) et éventuellement de moyens de mesure de la masse de l'échantillon (figure 1A).

La figure 2 est un schéma d'un dispositif selon l'invention constitué d'un palpeur en contact avec la surface d'un échantillon dans l'enceinte du four afin de mesurer son retrait.

La figure 3 est un schéma d'une coupe transversale d'un échantillon obtenu selon l'invention.

La figure 4 comporte une courbe (I) de transition entre croissance (zone A) et décroissance de l'oxyde de silicium (zone B) en fonction de la pression (en ppm) en espèce oxydante présente dans l'atmosphère entourant l'échantillon et de la température (°C) du traitement thermique lors du procédé de frittage.

La figure 5 est composée de courbes de granulométrie associées aux poudres de diamètre moyen (en $\mu$m) (M) et gros (G). Les mesures sont réalisées par granulométrie laser.

La figure 6 montre des courbes de perte de masse (en mg) de la poudre de granulométrie fine (F) en fonction de la température (en °C) pour différents exemples de vitesse de traitement thermique sous un débit constant de deux litres par heure.

La figure 7 est constituée de plusieurs courbes en fonction du temps (en min) de retrait de poudres avec des grains de diamètre fin (F), moyen (M) et gros (G), de tailles moyennes respectivement équivalentes à 200 nm, 14 $\mu$m et 130 $\mu$m lors d'un procédé de frittage selon l'invention. Les poudres sont préformées sous forme de comprimés de 8 mm de diamètre et d'environ 7 mm de hauteur. La température est montée jusqu'à 1350°C à une vitesse de 1,25°C/min et la pression d'eau contrôlée est égale à 80 ppm sous un débit constant de deux litres par heure.

La figure 8 comporte des courbes d'épaisseur d'oxyde (en nm) et de densité relative d'un échantillon en fonction du temps (en min) lors d'un procédé de frittage selon l'invention. La température est montée jusqu'à 1350°C à une vitesse de 0,625°C/min, sous une pression partielle d'eau constante, égale à 80 ppm atomique et un débit constant de deux litres par heure.

## EXPOSE DETAILLE DE MODES DE REALISATION

L'invention propose un procédé de frittage naturel pour contrôler l'épaisseur de la couche d'oxyde sur un matériau lors de son traitement thermique. Il est de cette façon possible de contrôler la densité ou/et la porosité du matériau.

Un dispositif puis un mode de réalisation d'un procédé selon l'invention sont exposés ci-après. Pour des raisons de clarté, les éléments identiques sur des figures différentes sont désignés par les mêmes références numériques.

Un exemple d'un dispositif pouvant être mis en oeuvre dans le cadre de l'invention va d'abord être décrit.

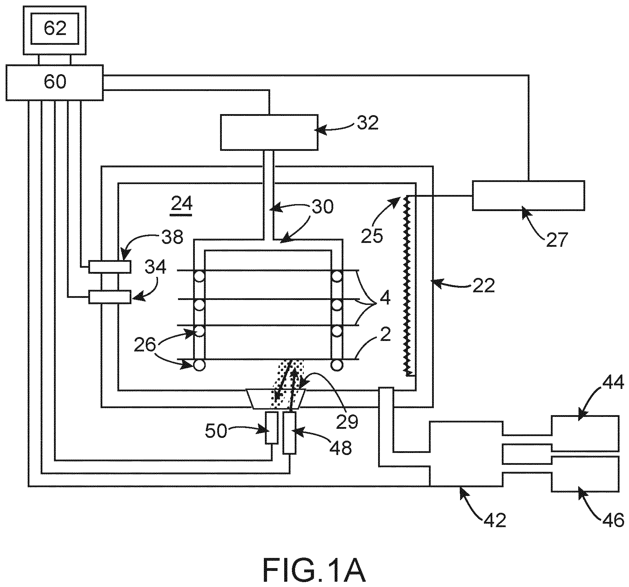

Ce dispositif comporte un four 22 (figure 1A) qui peut être chauffé, par exemple, par des résistances électriques 25 reliées à un boîtier de commande 27. Les moyens 25 et 27 permettent de réguler la température dans l'enceinte du four 24.

Des moyens 42 tels qu'un ensemble de débitmètres, sont reliés à une source de gaz vecteur 44 et à une source de gaz oxydant 46, par exemple de la vapeur d'eau. Ils permettent de contrôler le débit, la proportion et la pression d'un mélange des gaz 44 et 46. Ce mélange est ensuite introduit dans l'enceinte du four 24.

Une alternative possible, pour l'obtention du gaz comportant l'espèce oxydante, peut consister à faire barboter un gaz sec dans un bain thermostaté d'eau de façon à ce que le mélange gazeux atteigne la pression de vapeur d'eau souhaitée (quelques %). On peut alors réguler le débit du gaz vecteur comportant l'espèce oxydante, dans le cas présent de l'eau, à l'aide des moyens 42.

Une autre alternative peut consister à mettre sous vide l'enceinte 24. La pression partielle oxydante est alors régulée à l'aide d'une micro-fuite de gaz oxydant, par exemple de l'air vers l'intérieur de l'enceinte.

La température et la pression partielle en espèce oxydante du gaz entourant l'échantillon 2 ou les échantillons 2 et 4 sont mesurées par l'intermédiaire, respectivement, d'une sonde de température 34 et d'une sonde 38 permettant de mesurer la proportion d'espèce oxydante (ou pression partielle) comme par exemple une sonde hygrométrique. Une sonde et/ou les deux sondes peuvent être en contact ou non avec l'échantillon. Les matériaux composant les sondes sont choisis de façon à ne pas réagir avec l'échantillon, comme par exemple du tungstène avec un échantillon de silicium.

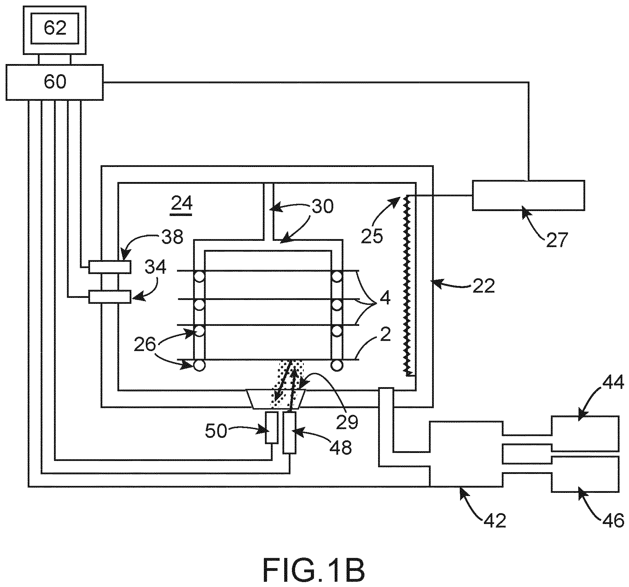

L'enceinte du four 24 peut comporter un ou plusieurs supports 26 maintenus par une structure 30 (figure 1B). La structure 30 peut être également suspendue à un dispositif de mesure de masse 32, par exemple une balance ou thermo-balance (figure 1A). On entend par "thermo-balance" une balance adaptée à fonctionner dans des milieux à températures élevées, mesurant la variation de masse de l'échantillon. Les supports 26 sont destinés à porter le ou les échantillons préformés 2 et 4. La structure 30 ainsi que les supports 26 sont réalisés dans une matière qui ne réagit pas avec le ou les échantillons. Dans le cas d'échantillons de silicium le métal choisi est par exemple du tungstène recouvert de silicium afin d'éviter tout phénomène d'interaction.

Le retrait de l'échantillon peut être mesuré par réflexion, sur une face de l'échantillon 2, d'un signal émis par une source laser 48. Le signal réfléchi est détecté par une diode photosensible 50 reliée à un dispositif électronique 60 afin de calculer le retrait de l'échantillon. Les moyens 48 et 50 sont placés, par exemple, à l'extérieur de l'enceinte du four 24. Les mesures sont réalisées à travers une ouverture ou un hublot 29 transparent à la longueur d'onde du laser.

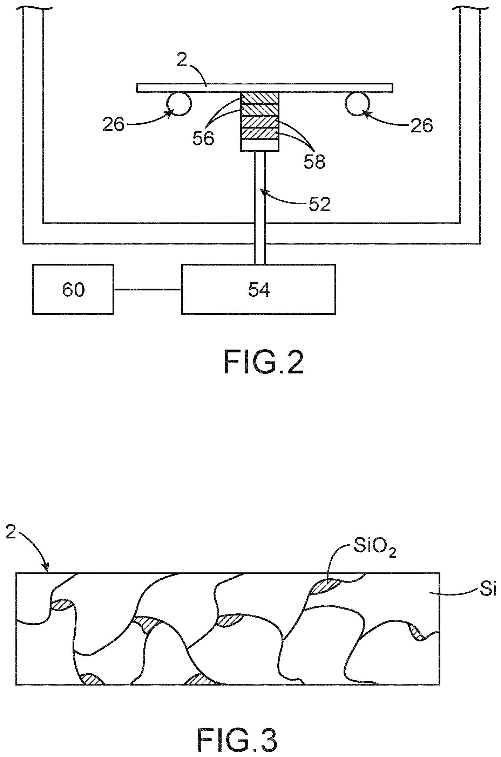

Tous autres dispositifs en contact ou non avec l'échantillon permettant de mesurer la variation de retrait de l'échantillon conviennent à la réalisation de cet aspect de l'invention. Par exemple, la mesure du retrait peut être réalisée à l'aide d'un palpeur 52, en contact avec l'échantillon 2, qui ne réagit pas avec l'échantillon. Afin d'éviter toute réaction entre le palpeur et le fritté, des plaquettes intermédiaires, par exemple deux plaquettes de silicium 56 et d'alumine 58, peuvent être intercalées entre un palpeur en alumine et la surface de l'échantillon 2 (figure 2). La variation de volume est calculée par les moyens (60) à partir des mesures de retrait réalisées par un boîtier 54 relié au palpeur (52).

Le dispositif comporte des moyens électroniques 60 tels qu'un ordinateur ou un calculateur. Les moyens de contrôle et de mesure 27, 32, 34, 38, 42, 48 et 50 sont reliés aux moyens électroniques 60. A partir de ces informations, les opérations de calcul sont réalisées par les moyens 60. Ces moyens peuvent être programmés pour mettre en oeuvre un procédé de frittage selon l'invention. Les paramètres du procédé comme par exemple la température et/ou la pression et/ou le débit et/ou le retrait et/ou la variation de masse de l'échantillon peuvent être contrôlés par les moyens 60. A partir des mesures et des paramètres du procédé de frittage, des calculs peuvent être réalisés par les moyens 60 tels que le calcul de la masse et/ou de l'épaisseur de la couche d'oxyde et/ou de la densité et/ou de la porosité de l'échantillon. Un écran d'affichage 62 permet de visualiser les différents paramètres et calculs sous forme de graphiques ou de valeurs afin de contrôler le procédé. Un opérateur peut en outre, à l'aide de ces moyens et de moyens formant une interface d'interaction tels qu'un clavier, entrer des consignes de régulation du système et/ou des paramètres du procédé mis en oeuvre, par exemple une température et/ou une montée en température et/ou une variation de pression et/ou de débit de gaz oxydant.

Dans une variante du dispositif ci-dessus l'expérimentateur peut s'affranchir de l'utilisation d'une thermo-balance en utilisant un modèle cinétique simple développé par l'inventeur. Dans ce cas, le dispositif comporte les moyens déjà décrits ci-dessus en liaison avec la figure 1A mais ne comporte plus de moyens 32, comme illustré en figure 1B. Ceci peut s'avérer plus simple à mettre en place et moins coûteux.

En faisant l'hypothèse que l'équilibre thermodynamique est toujours atteint et que la diffusion ne limite pas le départ des espèces, ce qui peut être le cas pour des plaquettes suffisamment fines (< 1 mm), la masse d'oxyde peut être estimée, par exemple pour du silicium et par exemple pour une espèce oxydante étant de l'eau, selon l'équation (1) suivante à l'aide des moyens 60:

$$m_{t+\Delta t}^{SiO_2} = m_t^{SiO_2} + \frac{Q}{RT_0}\left(P_t^{H_2O} - P_{eq}^{H_2O} - P_{eq}^{SiO}\right)\left(M_O + \frac{1}{2}M_{Si}\right) \times \Delta t \qquad (1)$$

où $P_{eq}^x$ et $M_x$ sont respectivement la pression partielle à l'équilibre et la masse molaire de l'espèce x, Q est le débit du gaz porteur dans l'enceinte, R la constante des gaz parfaits, $T_0$ la température à l'endroit où est mesuré le débit du gaz porteur et t, $\Delta t$ le temps et la variation de temps.

En parallèle, la densité relative de l'échantillon peut être calculée à l'aide de l'équation (2) en faisant l'hypothèse que le retrait est isotrope :

$$d_{t+\Delta t}^p = \frac{m_{t+\Delta t}^p}{\rho_{Si} \times V_t^p \left(1 + \frac{L_{t+\Delta t}^p - L_t^p}{L_t^p}\right)^3} \qquad (2)$$

où $m_{t+\Delta t}^p$ représente la masse de silice et de silicium constituant l'échantillon, $V_t^p$ le volume de l'échantillon à l'instant t et $L_t^p$ la mesure de la longueur de l'échantillon dans une des trois directions de l'espace à l'instant t, $\rho_x$ est la masse volumique de l'espèce x. Là encore, les calculs peuvent être faits à l'aide des moyens 60.

Un exemple de mise en oeuvre d'un procédé selon l'invention va maintenant être décrit.

Un échantillon est disposé dans un four tel que décrit ci-dessus. Par exemple une ou plusieurs préformes 4 sont introduites dans l'enceinte du four 24, elles peuvent être disposées sur les supports 26. Dans la suite du procédé, on considérera une seule préforme 2 par souci de clarté.

Le four est chauffé à une température permettant la réalisation d'un frittage, température qui reste inférieure à la température de fusion du matériau. A l'aide des moyens 42, la pression partielle en espèce oxydante (ici de l'eau) est contrôlée de manière à favoriser la croissance ou l'élimination d'une couche d'oxyde à la surface du matériau.

Pendant le frittage les mesures de perte de masse sont obtenues à l'aide d'une thermo-balance 32 reliée à la structure 30. La mesure du retrait du matériau est effectuée à l'aide des moyens 48, 50.

Dans le cas du silicium, le four est monté en température par les moyens 25 et 27 de façon à atteindre la gamme des très hautes températures qui se situe alors entre 1 000°C et la température de fusion, 1 414°C. La montée en température est de 0,625°C par minute.

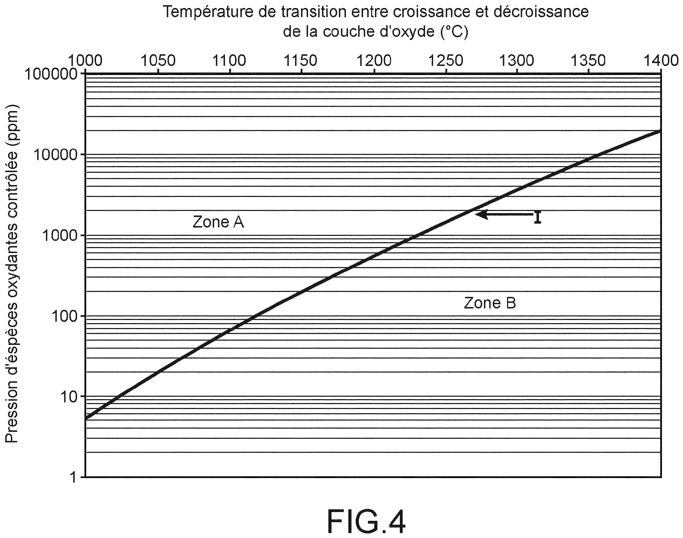

D'une manière générale, les conditions de température et de pression partielle d'espèces oxydantes sont préalablement choisies de manière à favoriser la croissance ou l'élimination de l'oxyde du matériau, par exemple à partir de données thermodynamiques de ce matériau. Sur la figure 4 qui rassemble de telles données pour le silicium, la courbe I délimite une zone A et une zone B. La zone A correspond au phénomène d'oxydation passive et à la formation de silice solide à la surface du silicium. Dans la zone B, le phénomène d'oxydation active se produit ce qui signifie que la silice est réduite par le silicium en une espèce gazeuse. Au cours du procédé de frittage, les conditions de pression et de température permettent de se situer dans la zone A ou la zone B, respectivement de formation ou d'élimination d'une couche d'oxyde.

Pour des températures comprises entre 400°C et 1 000°C, les mesures de masse de l'échantillon par le moyen 32 montrent une croissance de sa masse. Le silicium est oxydé de façon passive par l'eau selon la réaction 1 :

$$Si_{(s)} + 2H_2O_{(g)} \leftrightarrow SiO_{2(s)} + 2H_{2(g)} \qquad \textbf{Réaction 1 : Oxydation passive du silicium par l'eau}$$

Au-dessus de 1 000°C, l'inventeur a remarqué en fonction de la température, du débit et de la pression en gaz oxydant que l'échantillon peut perdre de la masse ce qui n'était pas prévu par la littérature.

En effet, selon M. Carl Wagner (Journal of Applied Physics, volume 29, number 9, september 1958), l'oxydation active du silicium est très fortement limitée par la présence d'une couche de silice à la surface du silicium. La couche de silice est selon l'auteur très imperméable aux espèces oxydantes. Dès lors, il était considéré que le silicium ne pouvait être oxydé activement que selon la réaction 2, une fois la couche de silice éliminée par une autre réaction 3 ayant lieu à plus haute température.

$$Si_{(s)} + H_2O_{(g)} \leftrightarrow SiO_{(g)} + H_{2(g)} \qquad \textbf{Réaction 2 : Oxydation active du silicium par l'eau}$$

$$SiO_{2(s)} + H_{2(g)} \leftrightarrow SiO_{(g)} + H_2O_{(g)} \qquad \textbf{Réaction 3 : Elimination de l'oxyde selon Wagner,}$$
**adapté au cas d'une atmosphère sous hydrogène**

Or, l'inventeur a démontré que l'attaque du silicium se produit également en présence de silice sur la surface du silicium selon la réaction 4 :

$$Si_{(s)} + SiO_{2(g)} \leftrightarrow 2SiO_{(g)} \qquad \textbf{Réaction 4 : Réduction de la silice par le silicium}$$

Les réactions précédentes de réduction et d'oxydation dépendent de deux paramètres : la température (dite température de transition) et de la pression de l'espèce ou des espèces oxydantes (dite pression de transition). Il est possible en contrôlant ces paramètres de favoriser l'une ou l'autre. Ces paramètres sont calculés à partir des données thermodynamiques disponibles dans la littérature (W. Malcolm and Jr. Chase. Nist-janaf thermochemical tables. In Journal of Physical and Chemical Reference Data, volume 9. American Chemical Society, American Institue of Physics, 4th edition, 1998). La courbe de la figure 4 est calculée à partir de ces données.

Il est donc possible de contrôler précisément la formation selon la réaction 1, et/ou l'élimination selon la réaction 4 de la couche de silice à la surface des grains de silicium en se plaçant dans la zone A ou B respectivement. Les réactions mises en jeux (réaction 1 ou 4) sont dans ces cas connues. Il est alors possible d'attribuer aux variations de masse de l'échantillon, la formation ou l'élimination des éléments impliqués dans les réactions 1 ou 4. A l'aide du calcul de masse de silice suivant, en faisant l'hypothèse que la diffusion ne limite pas le départ des espèces, on remonte de cette façon à l'épaisseur de la couche d'oxyde à la surface des poudres. On calcule la masse d'oxyde créée ou éliminée à partir des mesures réalisées par les moyens 32 selon l'équation (3):

$$si \left( \frac{\partial m}{\partial t} \right)_t > 0 \quad m_{t+\Delta t}^{SiO_2} = m_t^{SiO_2} + \Delta t \times \left( \frac{\partial m}{\partial t} \right)_t \times \left( 1 + \frac{M_{Si}}{2M_O} \right)$$

$$si \left( \frac{\partial m}{\partial t} \right)_t < 0 \quad m_{t+\Delta t}^{SiO_2} = m_t^{SiO_2} + \Delta t \times \left[ \left( \frac{\partial m}{\partial t} \right)_t + P_t^{H_2O} \times \frac{QM_{Si}}{RT_0} \right] \times \left( 1 - \frac{M_{Si}}{2(M_{Si} + M_O)} \right)$$

$$(3)$$

où $M_x$ représente la masse molaire de l'espèce x, $P^x_t$ est la pression partielle de l'espèce x à l'instant t, Q symbolise le débit du gaz porteur dans l'enceinte, R est la constante des gaz parfaits et $T_0$ représente la température à l'endroit où est mesuré le débit du gaz porteur.

A partir du calcul de la masse, il est alors possible de calculer la répartition de la quantité de silice à la surface des grains de silicium (dont les tailles sont connues) selon l'équation (4):

$$e^{SiO_2}_{t+\Delta t} = e^{SiO_2}_t + \frac{m^{SiO_2}_{t+\Delta t} - m^{SiO_2}_t}{S.S. \times m_{Si} \times \rho_{SiO_2}} \qquad (4)$$

où $m^x_t$ symbolise la masse d'espèce x à l'instant t, S.S. est la surface spécifique des poudres, $\rho_x$ la masse volumique de l'espèce x de masse $m_x$.

Selon une étape possible du procédé, à partir des mesures de masse et des équations (1) et (2) ou (3) et (4), l'épaisseur d'oxyde à la surface du silicium est calculée par les moyens 60.

Donc en contrôlant la vitesse de montée ou de descente en température par les moyens 25, 27 et 34, la pression et le débit en espèce oxydante par les moyens 42 et 38, on peut contrôler les réactions 1 et 4 dans le temps. Il est en conséquence possible de contrôler l'épaisseur de la couche de silice lors du procédé de frittage sans charge et d'en connaitre sa valeur.

D'autre part, l'opérateur peut prendre en compte la diffusion des espèces gazeuses ($H_2O$, SiO...) dans l'échantillon ou dans l'enceinte, par exemple, par mise en oeuvre d'une modélisation par éléments finis de la pièce qui permet de résoudre les équations classiques de convection-diffusion.

De plus, l'inventeur au cours de ces recherches a confirmé l'hypothèse de M. William S. Coblenz (Journal of Materials Science 25 (1990) 2754-2764)) selon laquelle la silice joue un rôle dans le phénomène de densification du silicium. M. Coblenz suppose que le frittage du silicium en présence d'oxyde permettrait d'inhiber le processus de diffusion de surface, non densifiant, au profit d'un phénomène densifiant. Grace au procédé selon l'invention, le processus de densification du silicium est contrôlé à partir du contrôle du traitement thermique (température et vitesse du traitement), et du contrôle de l'espèce oxydante au contact de l'échantillon (débit et/ou pression). En effet, les exemples ci-dessous de procédés selon l'invention montrent clairement une maitrise de la densité du matériau obtenu.

Un premier exemple de réalisation d'un procédé selon l'invention utilise une poudre de silicium d'une pureté 5N (>99,999 %). La pureté de la poudre est choisie en fonction des critères associés à l'application finale (par exemple le domaine du photovoltaïque). La poudre nommée F, possède une surface spécifique BET égale à 11,7 $m^2$/g. Cela correspond à des particules primaires de l'ordre de 220 nm avec une épaisseur d'oxyde natif égale à 0,46 nm. Les particules d'environ 220 nm sont regroupées en « colliers » qui peuvent atteindre quelques micromètres (tableau I):

| Poudre | Fournisseur | MEB | Retenu pour l'étude | | Morphologie |
|--------|-------------|-----|---------------------|--|-------------|
| | | | Surface Spécifique | Diamètre équivalent | |
| F | S'tile | # 200 nm | 11,7 $m^2$/g* | 220 nm* | Sphérique |
| M | Alfa Aesar Ref : 35662 | < 40 μm | 0,18 $m^2$/g** | 14 μm** | Particules Anguleuses |
| G | Alfa Aesar Ref : 36212 | # 100 – 300 μm | 0,02 $m^2$/g** | 130 μm** | Particules Anguleuses |

*Estimés à l'aide de la mesure de surface spécifique BET

**Estimés à l'aide de la mesure de granulométrie LASER

Tableau I

Pour cet exemple comme pour les suivants, les techniques employées pour caractériser les poudres utilisées sont l'observation par microscopie électronique à balayage (MEB), la granulométrie LASER et les mesures de surface spécifique par la méthode Méthode Brunauer, Emett et Teller (BET). Les mesures du tableau précédent ne prennent pas en compte les impuretés d'oxygène liées à la présence d'oxyde natif à la surface des poudres. La poudre peut donc posséder une épaisseur d'oxyde natif comprise entre zéro et 50 nm, de préférence entre 0 et 3 nm.

La poudre est préformée par des méthodes classiques liées à la technique du frittage, comme par exemple les méthodes utilisées dans le brevet FR N°2 934 186. On forme par compaction une pièce à cru cylindrique de 8 mm de diamètre et de 7 mm de hauteur. Le cru dans ce premier exemple de réalisation du procédé possède une densité relative égale à 53 %, tableau II :

| Poudre | Densité tassée | Pression de mise en forme | Densité à cru | Densité après frittage 1350°C – 3h |
|---|---|---|---|---|
| F | 4 % $\rho_{th}$ | 50 MPa Mise en forme uniaxiale 450 MPa Pression isostatique | 53 % $\rho_{th}$ | 63 % $\rho_{th}$ |
| M | 27 % $\rho_{th}$ | 900 MPa Pression uniaxiale | 63 % $\rho_{th}$ | 66 % $\rho_{th}$ |
| G | 34 % $\rho_{th}$ | 900 MPa Pression uniaxiale | 73 % $\rho_{th}$ | 75 % $\rho_{th}$ |

Tableau II

Les mesures de densité tassée présentées dans le tableau II sont réalisées à cru et après frittage à 1350°C pendant une heure.

Pour la poudre F, la préforme ou pièce à cru est réalisée en appliquant une pression uniaxiale faible égale à 50 MPa. On ne dépasse pas cette valeur afin que les grains ne se glissent pas entre le piston et la matrice ce qui entraînerait des risques de blocage de l'ensemble. Par la suite, une compression isostatique à froid est réalisée pour atteindre une densité à cru de 53%. Le retrait global pour cette poudre lors de l'étape de frittage est plus important que pour les poudres de plus grosses tailles, car le phénomène de retrait est favorisé avec des particules de petites dimensions (tableau III).

Un mélange gaz porteur He-$H_2$ (4 %) et gaz oxydant $H_2O$ (80 ppm) est utilisé. Le mélange de gaz est introduit dans l'enceinte 24 à un débit de 2 litres par heure, réglé et contrôlé respectivement par les moyens 42 et 38.

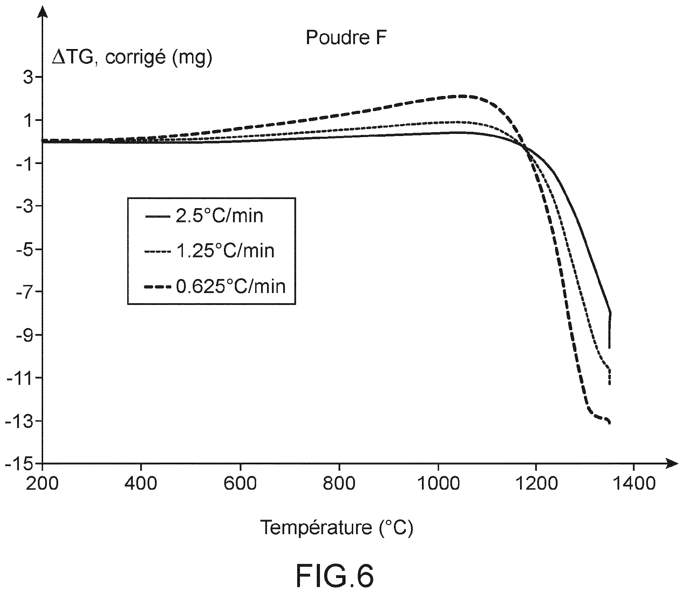

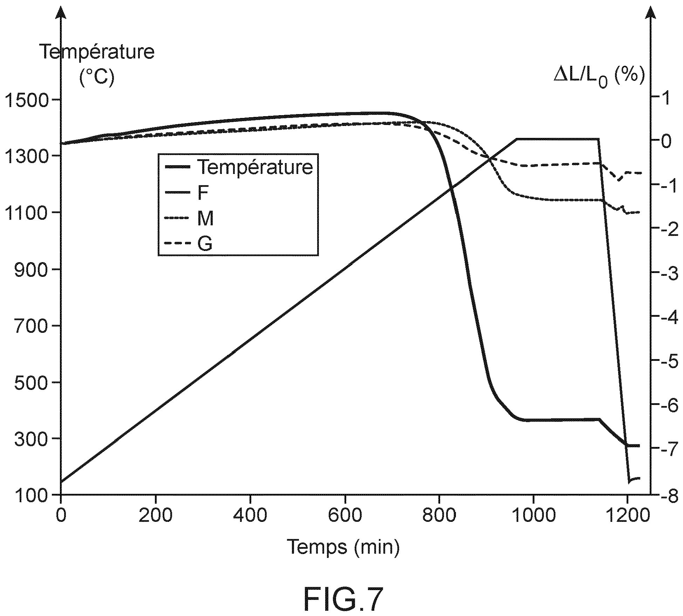

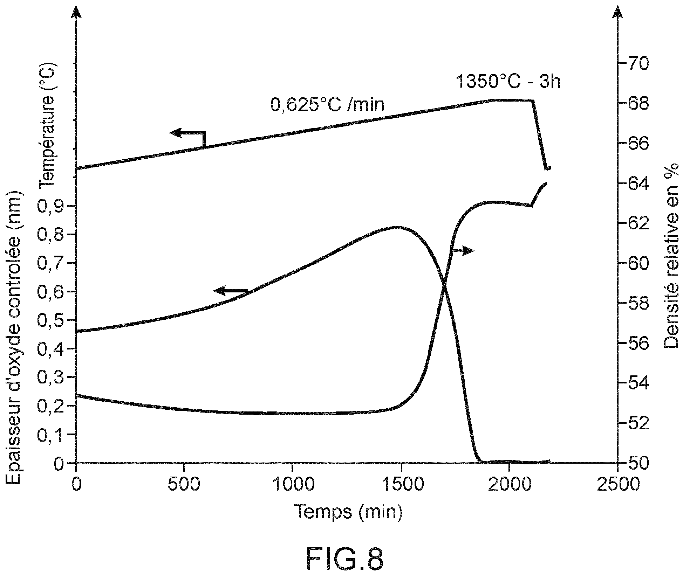

A partir des mesures de la variation de masse du matériau (figure 6) et de retrait du fritté (figure 7), la densité de la pièce est calculée par les moyens 60. Ces mesures et les valeurs sont reportées sur la figure 8 qui peuvent être affichées sur l'écran 62. A l'aide de la figure 8, l'opérateur peut contrôler l'épaisseur de silice à la surface des poudres et le retrait en parallèle pendant le procédé de frittage selon l'invention.

Selon une variante du procédé précédent, l'opérateur fixe la pression en espèce oxydante à 80 ppm et fait varier la température de façon à se situer dans la zone B de la figure 4 durant le procédé de frittage afin de favoriser le départ de l'ensemble de l'oxyde avant que le comprimé de poudre F n'atteigne une densité supérieure à 63 %.

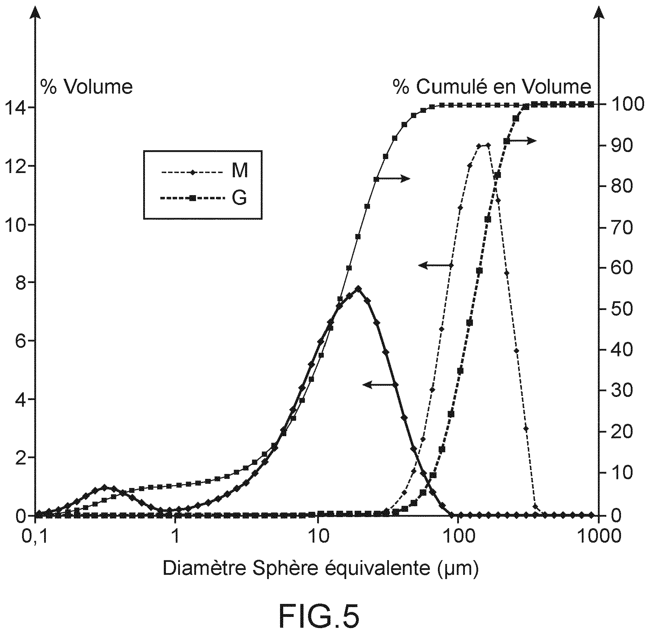

Selon un autre exemple de mise en oeuvre du procédé, une poudre de silicium nommée M, de pureté similaire à la poudre F, est utilisée. La poudre M possède des cristaux dont le diamètre équivalent est centré autour de 14 $\mu$m (tableau I). Des particules plus fines sont associées à des cristaux anguleux dont le diamètre équivalent est centré autour de 300 nm (figure 5). Ces particules fines représentent un peu moins de 10 % du volume.

La poudre M possède une très bonne coulabilité, en partie liée à sa morphologie qui se prête peu à la formation d'agglomérats. Les plaquettes sont mises en forme, sans liant, en appliquant une tenue contrainte uniaxiale d'au moins 900 MPa afin d'obtenir une tenue mécanique. La densité à cru est de l'ordre de 63 % avant frittage, elle augmente après frittage à 66 % (tableau II).

Un troisième exemple de réalisation selon l'invention utilise une poudre de silicium nommée G, de pureté similaire à la poudre F. La poudre G possède des cristaux très grossiers dont le diamètre équivalent est compris entre 50 et 300 $\mu$m (tableau I, figure 5).

La poudre possède une très bonne coulabilité, en partie liée à sa morphologie qui se prête peu à la formation d'agglomérats. Les plaquettes sont mises en forme, sans liant, en appliquant une tenue contrainte uniaxiale supérieure à 900 MPa afin d'obtenir une tenue mécanique. La densité à cru est de l'ordre de 73 % avant frittage, elle est de 75 % après (tableau II).

Le tableau suivant (tableau III) reporte les mesures de dilatation thermique, de retrait et de perte de masses observés et calculés pour les poudres F, M et G, lors d'un traitement thermique à une vitesse de 1,25°C /min pour atteindre un pallier de 1350°C.

| Poudre | Dilatation (%) 150 – 1000 ℃ | Retrait global (%) | Perte de masse observée (%) | Epaisseur d'oxyde estimée (nm) |
|---|---|---|---|---|
| F | 0,65 | 6,9 | 2,7 | 0,5 |
| M | 0,41 | 1,6 | 3,4 | 25 |
| G | 0,41 | 0,7 | 0,9 | 5 |

Tableau III

Selon un autre exemple de réalisation d'un procédé selon l'invention une poudre de silicium de surface spécifique BET égale à 51,6 m$^2$/g est utilisée. La valeur de la surface spécifique correspond à des particules primaires de l'ordre de 50 nm, avec une épaisseur d'oxyde natif égale à 0,5 nm. La pièce formée selon le procédé de l'invention possède une densité relative égale à 51 %.

La pression partielle d'eau dans le gaz est toujours gardée constante et égale à 80 ppm. La température de traitement thermique est augmentée selon une vitesse de 50°C/min. Lorsque l'enceinte atteint une température de 1 350°C, une majorité de silice reste présente dans le matériau. Les plaquettes de silicium obtenues ont alors le temps de se densifier à 98 % avant le retrait global de la silice. Une autre alternative consiste à conserver une vitesse faible en augmentant la pression en espèces oxydantes pour atteindre le même résultat.

L'un des procédés précédents peut éventuellement comporter au moins une étape supplémentaire de recouvrement d'un ou de plusieurs échantillons, par un mélange de préférence équimolaire de poudres de silicium et de silice, avant de traiter thermiquement lesdits échantillons. Cette poudre, nommée par la suite poudre de recouvrement, peut recouvrir partiellement ou entièrement au moins un échantillon. Par exemple, un volume de poudre de recouvrement peut comporter plusieurs échantillons superposés et/ou juxtaposés, séparés entre eux par ladite poudre.

Lors du traitement thermique d'un échantillon ou comprimé, la poudre de recouvrement libère des espèces oxydantes de type SiO, selon la réaction 4. De cette façon, la pression en espèce oxydante entourant l'échantillon est homogène et égale à la pression d'équilibre.

De préférence, l'épaisseur de cette poudre de recouvrement est à la surface d'un comprimé, d'épaisseur égale ou similaire, selon une direction perpendiculaire à ladite surface. Ainsi, une répartition homogène des espèces oxydantes autour, et éventuellement dans un échantillon, peut être favorisée.

De cette façon, l'épaisseur de la couche de silice présente sur les grains de silicium composant un échantillon, est similaire ou égale, avant et pendant le traitement thermique. Autrement dit, tant que le mélange de poudre de Si-SiO$_2$ entoure un échantillon, l'épaisseur d'oxyde présent à la surface des grains de silicium composant l'échantillon est constante ou similaire.

Selon une seconde étape, lorsqu'un échantillon atteint la densité souhaitée, celui-ci est isolé de la poudre de recouvrement. Il peut soit être retiré du mélange de poudre, soit la poudre peut être éloignée de l'échantillon, par exemple par un procédé de type aspiration.

L'échantillon peut ensuite être traité, à haute température sous gaz sec par exemple, pour retirer toute ou partie de la silice restante dans l'échantillon. La porosité et la quantité de silice rémanente sont ainsi contrôlées.

Avantageusement, la poudre de recouvrement peut permettre de réaliser l'un des procédés précédents, sans introduire de gaz oxydants dans l'enceinte du four. Il est alors possible de réaliser l'un des procédés ci-dessus dans des fours où la présence d'espèces oxydantes n'est pas parfaitement contrôlée, ou bien n'est pas homogène autour du comprimé.

Afin de limiter les phénomènes de perte de poudre de recouvrement, par départ de SiO (voir réaction 4 et 3), les étapes de traitement thermique peuvent être réalisées dans une enceinte hermétique ou partiellement hermétique, et de préférence non soumise à des mouvements de circulation de gaz.

Un procédé selon l'invention peut comporter une étape de retrait ou d'élimination, au moins partiellement, d'une couche d'oxyde présente à la surface d'un échantillon. Cette étape peut par exemple être réalisée selon un traitement chimique à base de HF. Cette étape précède de préférence l'étape permettant de retirer toute ou partie de la silice restante dans l'échantillon, selon l'un des procédés de frittage ci-dessus.

Les procédés de frittage sans charge, selon l'invention, permettent de maitriser l'épaisseur de la couche d'oxyde présente en surface et dans le matériau pendant le procédé de frittage. Le contrôle de l'épaisseur de la couche d'oxyde sur les grains de silicium permet de contrôler la densité et la porosité du matériau pendant et après le frittage.

Les matériaux élaborés grâce à ce nouveau procédé sont utilisables dans de nombreuses applications comme par exemple :

- la réalisation de plaquettes denses de silicium, sans oxydes résiduels, pour des applications photovoltaïques ou thermoélectriques,

- la réalisation d'électrodes à porosité contrôlée (pour des batteries),
- la réalisation de couches de nano-cristaux de silicium, entourées d'une épaisseur d'oxyde contrôlée, de l'ordre du nanomètre, pour des applications dans les domaines du photovoltaïque ou de l'électroluminescence, basées sur l'effet du confinement quantique.

D'autres applications sont possibles dans les domaines de l'optique, optoélectronique, électronique, microélectronique, etc.

## Revendications

1. Procédé de contrôle de la densité et/ou de la porosité d'un échantillon de silicium, ce procédé comportant :

   • un positionnement de cet échantillon de silicium, initialement sous forme granulaire ou de poudre, dans un four,
   • détermination des conditions de température de frittage et de pression partielle des espèces oxydantes pour exécuter une étape de frittage,
   • un frittage sans charge de cet échantillon, par traitement thermique de celui-ci à au moins une température de frittage et au moins une pression partielle d'espèces oxydantes, la température de frittage restant inférieure à la température de fusion de l'échantillon, la température de frittage et la pression partielle d'espèces oxydantes étant commandées pendant le frittage pour favoriser une croissance ou une élimination d'une couche d'oxyde de manière à contrôler l'épaisseur de ladite couche d'oxyde de silicium à la surface de l'échantillon, la croissance et l'élimination de la couche d'oxyde étant respectivement régies par les réactions chimiques :

$$Si_{(s)} + 2H_2O_{(g)} \leftrightarrow SiO_{2(s)} + 2H_{2(g)}$$

   Et

$$Si_{(s)} + SiO_{2(g)} \leftrightarrow 2SiO_{(g)}.$$

2. Procédé selon la revendication 1, dans lequel, pendant le procédé de frittage, au moins une mesure de la masse de l'échantillon est réalisée ou au moins un calcul de la masse de l'échantillon est effectué.

3. Procédé selon la revendication 1 ou 2, dans lequel l'épaisseur de la couche d'oxyde est calculée à partir d'au moins une mesure de masse de l'échantillon.

4. Procédé selon l'une des revendications précédentes, dans lequel au moins une mesure de retrait de l'échantillon est réalisée pendant le procédé de frittage.

5. Procédé selon la revendication 4 en combinaison avec la revendication 2, comportant en outre un calcul de densité du matériau à partir d'au moins une mesure du retrait du matériau et d'au moins une mesure de masse de l'échantillon et/ou au moins un calcul de la masse de l'échantillon.

6. Procédé selon l'une des revendications précédentes, dans lequel la température de frittage et/ou la pression partielle varie(nt).

7. Procédé selon l'une des revendications 1 à 5, dans lequel la température de frittage et/ou la pression partielle reste(nt) constante(s).

8. Procédé selon l'une des revendications précédentes, dans lequel les grains sont de diamètre équivalent inférieur à 500 μm, de préférence inférieur à 5 μm, de préférence inférieur à 500 nm, ou sont composés d'un mélange de grains de diamètres différents.

9. Procédé selon la revendication précédente, dans lequel les poudres comportant des grains de diamètre équivalent supérieur à 500 nm sont préformées par compression supérieure ou égale à 900 MPa ou dans lequel les poudres comportant des grains de diamètre équivalent inférieur à 500 nm sont préformées par compression inférieure à 600 MPa.

**10.** Procédé selon l'une des revendications précédentes, dans lequel l'épaisseur de la couche d'oxyde sur les grains est comprise de préférence inférieure à 50 nm, de préférence inférieure à 20 nm, de préférence encore inférieure à 3 nm.

**11.** Dispositif de contrôle de la densité et/ou de la porosité d'un échantillon de silicium, comportant un four pour réaliser un frittage sans charge de cet échantillon, ce four comportant :

* des moyens de contrôle de la température de l'enceinte du four, de manière à ce que la température de l'échantillon, lorsqu'il est disposé dans le four, reste inférieure à sa température de fusion,
* des moyens de contrôle de la pression partielle d'une ou de plusieurs espèces oxydantes dans le four,
* des moyens commandant, pendant un frittage, les moyens de contrôle de la température et de la pression partielle d'une ou de plusieurs espèces oxydantes dans le four, de sorte à contrôler la croissance ou l'élimination d'une couche d'oxyde sur le silicium et ainsi contrôler l'épaisseur d'une couche d'oxyde sur le silicium, la croissance et l'élimination de la couche d'oxyde étant respectivement régies par les réactions chimiques :

$$Si_{(s)} + 2H_2O_{(g)} \leftrightarrow SiO_{2(s)} + 2H_{2(g)}$$

Et

$$Si_{(s)} + SiO_{2(g)} \leftrightarrow 2SiO_{(g)}.$$

**12.** Dispositif selon la revendication précédente, comportant des moyens de mesure et/ou de calcul de la masse de l'échantillon pendant le frittage.

**13.** Dispositif selon la revendication précédente, comportant des moyens de calcul de l'épaisseur d'une couche d'oxyde en fonction de la masse de l'échantillon.

**14.** Dispositif selon les revendications 11 à 13, comportant des moyens de mesure de retrait de l'échantillon de silicium, les moyens de mesure de retrait étant par exemple de type par contact ou à distance.

**15.** Dispositif selon la revendication 14 en combinaison avec la revendication 13, comportant en outre des moyens de calcul de volume et/ou de densité et/ou de porosité du matériau à partir de la masse et du retrait de l'échantillon.

**Patentansprüche**

**1.** Verfahren zur Kontrolle der Dichte und/oder Porosität einer Siliziumprobe, wobei das Verfahren umfasst:

* eine Positionierung der Siliziumprobe in einem Ofen, anfänglich als Granulat oder Pulver,
* Bestimmung der Sintertemperatur- und Partialdruck-Bedingungen der Oxidationsspezies zur Durchführung eines Sinterschrittes,
* Sintern ohne Beladung dieser Probe durch Wärmebehandlung derselben bei wenigstens einer Sintertemperatur und wenigstens einem Partialdruck der Oxidationsspezies, wobei die Sintertemperatur kleiner bleibt als die Schmelztemperatur der Probe, wobei die Sintertemperatur und der Partialdruck der Oxidationsspezies während des Sinterns gesteuert werden, um ein Anwachsen oder eine Eliminierung einer Oxidschicht zu steuern, um die Dicke der Siliziumoxidschicht an der Oberfläche der Probe zu steuern, wobei das Anwachsen und die Eliminierung der Oxidschicht jeweils durch chemische Reaktionen gesteuert werden:

$$Si_{(s)} + 2H_2O_{(g)} \leftrightarrow SiO_{2(s)} + 2H_{2(g)}$$

und

$$Si_{(s)} + SiO_{2(g)} \leftrightarrow 2SiO_{(g)}.$$

**2.** Verfahren nach Anspruch 1, bei welchem während des Sinterverfahrens wenigstens eine Messung der Probenmasse durchgeführt wird oder wenigstens eine Berechnung der Probenmasse ausgeführt wird.

3. Verfahren nach Anspruch 1 oder 2, bei welchem die Dicke der Oxidschicht mittels wenigstens einer Messung der Probenmasse berechnet wird.

4. Verfahren nach einem der vorhergehenden Ansprüche, bei welchem wenigstens eine Messung der Probenentfernung während des Sinterverfahrens durchgeführt wird.

5. Verfahren nach Anspruch 4 in Kombination mit Anspruch 2, welches ferner eine Berechnung der Dichte des Materials auf der Grundlage wenigstens einer Messung der Materialentfernung und wenigstens einer Messung der Probenmasse und/oder wenigstens einer Berechnung der Probenmasse umfasst.

6. Verfahren nach einem der vorhergehenden Ansprüche, bei welchem die Sintertemperatur und/oder der Partialdruck schwanken.

7. Verfahren nach einem der Ansprüche 1 bis 5, bei welchem die Sintertemperatur und/oder der Partialdruck konstant bleiben.

8. Verfahren nach einem der vorhergehenden Ansprüche, bei welchem die Körner einen äquivalenten Durchmesser kleiner 500 $\mu$m, bevorzugt kleiner 5 $\mu$m, bevorzugt kleiner 500 nm aufweisen, oder aus einer Mischung von Körnern mit unterschiedlichem Durchmesser zusammengesetzt sind.

9. Verfahren nach einem der vorhergehenden Ansprüche, bei welchem die Pulver, welche Körner mit äquivalentem Durchmesser größer 500 $\mu$m umfassen, durch eine Komprimierung bei größer oder gleich 900 MPa vorgeformt werden oder bei welchem die Pulver, welche Körner mit äquivalentem Durchmesser kleiner 500 $\mu$m umfassen, durch eine Komprimierung bei kleiner 600 MPa vorgeformt werden.

10. Verfahren nach einem der vorhergehenden Ansprüche, bei welchem die Dicke der Oxidschicht auf den Körner bevorzugt kleiner 50 nm, bevorzugt kleiner 20 nm, weiterhin bevorzugt kleiner 3 nm ist.

11. Mittel zur Kontrolle der Dichte und/oder Porosität einer Siliziumprobe, welches einen Ofen zur Durchführung des Sinterns ohne Beladung dieser Probe umfasst, wobei der Ofen aufweist:

   * Mittel zur Kontrolle der Temperatur des Ofenraums, so dass die Temperatur der Probe, wenn diese im Ofen platziert wird, kleiner bleibt als seine Schmelztemperatur,
   * Mittel zur Kontrolle des Partialdruckes einer oder mehrerer Oxidationsspezies im Ofen,
   * Mittel, die während eines Sinterns die Mittel zur Kontrolle der Temperatur und des Partialdruckes einer oder mehrerer Oxidationsspezies im Ofen steuern, um das Wachstum oder die Eliminierung einer Oxidschicht auf dem Silizium zu steuern und so die Dicke einer Oxidschicht auf dem Silizium zu steuern, wobei das Wachstum und die Eliminierung der Oxidschicht jeweils durch chemische Reaktionen geregelt werden:

$$Si_{(s)} + 2H_2O_{(g)} \leftrightarrow SiO_{2(s)} + 2H_{2(g)}$$

und

$$Si_{(s)} + SiO_{2(g)} \leftrightarrow 2SiO_{(g)}.$$

12. Vorrichtung nach dem vorhergehenden Anspruch, welche Mittel zum Messen und/oder Berechnen der Probenmasse während des Sinterns umfasst.

13. Vorrichtung nach dem vorhergehenden Anspruch, welche Mittel zur Berechnung der Dicke einer Oxidschicht abhängig von der Probenmasse umfasst.

14. Vorrichtung nach einem der Ansprüche 11 bis 13, welche Mittel zur Messung der Entfernung der Siliziumprobe umfasst, wobei die Mittel zur Messung der Entfernung beispielsweise vom Kontakt- oder Abstandstyp sind.

15. Vorrichtung nach Anspruch 14 in Kombination mit Anspruch 13, welche ferner Mittel zur Berechnung des Volumens und/oder der Dichte und/oder der Porosität des Materials auf der Basis der Masse und der Entfernung der Probe umfasst.

**Claims**

1. Method for controlling the density and/or porosity of a silicon sample, the method comprising:

 • positioning of the silicon sample, initially in granular or powder form, in a furnace,
 • determining conditions of sintering temperature and partial pressure of oxidizing species in order to perform a sintering step,
 • a load-free sintering of the sample, by heat treatment thereof at at least one sintering temperature and at least one partial pressure of oxidizing species, the sintering temperature remaining below the melting temperature of the sample, the sintering temperature and the partial pressure of oxidizing species being controlled during sintering to favour growth or elimination of an oxide layer so as to control the thickness of said silicon oxide layer at the surface of the sample, the growth and the elimination of the oxide layer being respectively governed by the chemical reactions:

$$Si_{(s)} + 2H_2O_{(g)} \leftrightarrow SiO_{2(s)} + 2H_{2(g)}$$

 and

$$Si_{(s)} + SiO_{2(g)} \leftrightarrow 2SiO_{(g)}.$$

2. Method according to claim 1, in which at least one measurement of the sample mass or at least one calculation of the sample mass is made during the sintering method.

3. Method according to claim 1 or 2, in which the thickness of the oxide layer is calculated from at least one measurement of the mass of the sample.

4. Method according to one of the previous claims, in which at least one measurement of the shrinkage of the sample is made during the sintering method.

5. Method according to claim 4 combined with claim 2, also comprising a calculation of the density of the material starting from at least one measurement of the shrinkage of the material and at least one measurement of the sample mass and/or at least one calculation of the sample mass.

6. Method according to one of the previous claims, in which the sintering temperature and/or the partial pressure varies.

7. Method according to one of claims 1 to 5, in which the sintering temperature and/or the partial pressure remains constant.

8. Method according to one the previous claims, in which the grains have an equivalent diameter less than 500 $\mu$m, preferably less than 5 $\mu$m, preferably less than 500 nm or composed of a mix of grains with different diameters.

9. Method according to the previous claim, in which powders comprising grains with equivalent diameter more than 500 nm are preformed by compression of more than or equal to 900 MPa or in which powders comprising grains with equivalent diameter less than 500 nm are preformed by compression of less than 600 MPa.

10. Method according to one of the previous claims, in which the thickness of the oxide layer on the grains is preferably less than 50 nm, preferably less than 20 nm, and even more preferably less than 3 nm.

11. Device for controlling the density and/or the porosity of a silicon sample, comprising a furnace for performing a load-free sintering of the sample, said furnace comprising:

 - means for controlling the temperature of the furnace chamber, so that the temperature of the sample, when disposed in the furnace, is kept below the melting temperature of the sample,
 - means for controlling the partial pressure of one or several oxidising species in the furnace,
 - means for commanding, during the sintering, the temperature and the partial pressure of one or several oxidising species control means in the furnace so as to control the growth or the elimination of the thickness of an oxide layer on the silicon, the growth and the elimination of the oxide layer being respectively governed by the chemical reactions:

$$Si_{(s)} + 2H_2O_{(g)} \leftrightarrow SiO_{2(s)} + 2H_{2(g)}$$

and

$$Si_{(s)} + SiO_{2(g)} \leftrightarrow 2SiO_{(g)}.$$

12. Device according to claim 11, comprising means for measuring and/or calculating the mass of the sample during the sintering.

13. Device according to claim 12, comprising means for calculating the thickness of the oxide layer as a function of the mass of the sample.

14. Device according to one of claims 11 to 13, comprising means for measuring the shrinkage of the silicon sample, means for measuring the shrinkage being for example contact means or distance means.

15. Device according to claim 14 combined with claim 13, further comprising means for calculating the volume and/or the density and/or the porosity of the material starting from the mass and the shrinkage of the sample.

FIG.1A

FIG.1B

FIG.2

FIG.3

FIG.4

FIG.5

FIG.6

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2940520
- WO 2004093202 A1
- FR 2931297
- FR 2934186

**Littérature non-brevet citée dans la description**

- **C. GRESKOVICH et al.** Sintering of Covalent Solids. *Journal of the American Ceramic Society,* 1976, vol. 59 (7-8), 336-343
- **CARL WAGNER.** *Journal of Applied Physics,* Septembre 1958, vol. 29 (9
- *Journal of Materials Science,* 1979, vol. 14 (11), 2733-2740
- **M. CARL WAGNER.** *Journal of Applied Physics,* Septembre 1958, vol. 29 (9
- Nist-janaf thermochemical tables. **W. MALCOLM ; JR. CHASE.** In Journal of Physical and Chemical Reference Data. American Chemical Society, American Institue of Physics, 1998, vol. 9
- **M. WILLIAM ; S. COBLENZ.** *Journal of Materials Science,* 1990, vol. 25, 2754-2764